# EUROPEAN PATENT APPLICATION

(11) **EP 4 707 434 A1**
(43) Date of publication of application: **11.03.2026**
(21) Application number: 24800119.0
(22) Date of filing: 01.05.2024
(51) Int. Cl.: C30B 15/08, C30B 29/52, F27B 14/20, F27D 11/06

(54) **PRODUCTION DEVICE, CRYSTAL GROWTH METHOD, AND ALLOY MEMBER**

(30) Priority: 01.05.2023 JP 2023075899
(71) Applicant: C & A Corporation, Sendai-shi, Miyagi 980-0811 (JP); Tohoku University, Sendai-shi, Miyagi 980-8577 (JP)
(72) Inventor: MURAKAMI, Rikito, Sendai-shi, Miyagi 980-8577 (JP); YOSHIKAWA, Akira, Sendai-shi, Miyagi 980-8577 (JP); KAMADA, Kei, Sendai-shi, Miyagi 980-8577 (JP); YONEMURA, Kotaro, Sendai-shi, Miyagi 980-8577 (JP); YAMAGUCHI, Hiroaki, Sendai-shi, Miyagi 980-0811 (JP); ITOI, Shiika, Sendai-shi, Miyagi 980-0811 (JP); SHOJI, Yasuhiro, Sendai-shi, Miyagi 980-0811 (JP)
(74) Representative: Samson & Partner Patentanwälte mbB
(86) International application number: PCT/JP2024/016769
(87) International publication number: WO 2024/228388

(57) **Abstract**

Provided is a crystal growth method for growing a crystal through a thermal reaction of a raw material workpiece under high-frequency induction heating, wherein the method grows a crystal while controlling the raw material workpiece in accordance with a rate of change of the detected frequency. The frequency in the high-frequency induction heating is detected, and in accordance with the rate of change of the detected frequency, the crystal growth conditions are controlled according to the rate of change of the detected frequency.

## Description

### TECHNICAL FIELD

The present invention relates to a manufacturing apparatus for growing a crystal, a crystal growth method, and an alloy component.

### BACKGROUND ART

Conventionally, various apparatuses have been used and investigated for growing crystals. Patent Document 1 discloses a crystal growth method wherein a circuit element is controlled so that the heating oscillation frequency is constant, and the diameter of the growing crystal is controlled by adjusting the moving speed of the crystal. However, such crystal growth methods are not sufficient to deal with frequencies during, for example, crystal formation, nor do they deal precisely with spike-like frequency changes that affect crystallinity. In particular, there are problems such as poor crystallinity due to the need to control the moving speed of the crystal, not necessarily resulting in satisfaction.

### PRIOR ART DOCUMENT

Patent Document 1 : Japanese examined patent publication No. S60-024077

### SUMMARY OF THE INVENTION

### Problem to be solved by the invention

An object of the invention is to provide a manufacturing apparatus and a crystal growth method that can grow a crystal with excellent crystallinity.

### Means to solve the problem

As a result of intensive research to achieve the above-mentioned object, the inventors have made various discoveries, including that in a crystal growth method for growing a crystal through a thermal reaction of a raw material workpiece under high-frequency induction heating, the method comprises:
a frequency detection step of detecting a frequency associated with the high frequency induction heating; and
a step of controlling the raw material workpiece in accordance with a rate of change of the frequency detected in the frequency detection step. Such a crystal growth method not only significantly improves the crystallinity, but also makes it easy and enhances to produce the crystal industrially, particularly in continuous supply, among others. The inventors have found that such a crystal growth method and manufacturing apparatus can solve the above-mentioned issues of conventional methods and apparatuses. In addition, after the above findings, the inventors further conducted research and completed the invention.

The present invention relates to the following subject matters:
[1] A manufacturing apparatus for growing a crystal through a thermal reaction of a raw material workpiece under high-frequency induction heating, wherein
   the manufacturing apparatus comprises a frequency detection means for detecting a frequency associated with the high frequency induction heating; and
   the raw material workpiece is controlled in accordance with a rate of change of the frequency detected by the frequency detection means.
[2] The manufacturing apparatus according to above [1], wherein the raw material workpiece includes a crystal rod.
[3] The manufacturing apparatus according to above [1], further comprising a continuous supply means for continuously supplying the raw material workpiece while controlling the raw material workpiece.
[4] The manufacturing apparatus according to above [1], further comprising a means for stopping an operation of the manufacturing apparatus in accordance with a rate of change of a center frequency during a change of the frequency.
[5] The manufacturing apparatus according to above [1] above, further comprising a cooling heat-treatment means for carrying out the growth by cooling heat-treatment.
[6] The manufacturing apparatus according to above [1], further comprising a high-frequency induction heating means for carrying out the high-frequency induction heating.
[7] The manufacturing apparatus according to above [6], wherein the high-frequency induction heating means includes a heating coil, wherein the control is carried out by moving the position of the heating coil.
[8] The manufacturing apparatus according to above [1], further comprising a means for driving the raw material workpiece.
[9] The manufacturing apparatus according to above [8], further comprising a supply amount adjustment means for adjusting the supply amount of the raw material workpiece, wherein the control is carried out by the supply amount adjustment means.
[10] The manufacturing apparatus according to above [1], the manufacturing apparatus is a µ-PD device.
[11] A crystal growth method for growing a crystal through a thermal reaction of a raw material workpiece under high-frequency induction heating, the method comprising:
   a frequency detection step of detecting a frequency associated with the high frequency induction heating; and
   a step of controlling the raw material workpiece in accordance with a rate of change of the frequency detected in the frequency detection step.
[12] The crystal growth method according to above [11], wherein the raw material workpiece includes a crystal rod.
[13] The crystal growth method according to above [11], further comprising a step of continuously supplying the raw material workpiece while controlling the raw material workpiece.
[14] The crystal growth method according to above [11], wherein an operation of the apparatus is stopped according to the rate of change of the center frequency in the frequency change.
[15] The crystal growth method according to above [11], wherein the growth is carried out by a cooling heat-treatment.
[16] The crystal growth method according to above [11], wherein the control is carried out by moving a high-frequency induction heating portion in the high-frequency induction heating.
[17] The crystal growth method according to above [11], wherein the control is carried out by driving the raw material workpiece.
[18] The crystal growth method according to above [11], wherein the control is carried out by adjusting the supply amount of the raw material workpiece.
[19] The crystal growth method according to above [11], wherein the crystal is grown by a µ-PD method.

The alloy component according to the present invention is an alloy component manufactured by the above-described crystal growth method.

The alloy component according to the present invention contains a precious metal, has length of 30 meters or more, and has a composition error range of alloy elements in a longitudinal direction of 1 atomic % or less.

In one example of the alloy component, the alloy component has length of 35 meters or more.

### Advantageous effects of the invention

As explained above, in accordance with the present invention, a crystal with excellent crystallinity can be grown industrially advantageously.

### BRIEF DESCRIPTION OF THE DRAWINGS

FIG. 1 schematically shows a preferred example of a manufacturing apparatus according to an embodiment of the invention.
FIG. 2 schematically shows a comparison between a normal center frequency and an abnormal center frequency in the embodiment of the invention.
FIG. 3 schematically shows an example of a work amount flow adjusted according to the rate of change of the frequency in FIG.2.
FIG. 4 shows a relationship between the concentration of solute metal elements and the crystallization rate in % in Embodiment 1 and Comparative Example.

### DETAILED DESCRIPTION OF THE INVENTION

The manufacturing apparatus according to an embodiment of the invention is a manufacturing apparatus for growing a crystal through a thermal reaction of a raw material workpiece under high-frequency induction heating, wherein the manufacturing apparatus comprises a frequency detection means for detecting a frequency in the high-frequency induction heating; and the raw material workpiece is controlled in accordance with a rate of change of the frequency detected by the frequency detection means. The rate of change of the frequency, including whether or not there is a change, can be determined based on whether the frequency is within a predetermined range. Alternatively, a normal rate of change of the frequency can be obtained in advance, and the range of the obtained normal rate of change of the frequency can be set as the predetermined range. In accordance with an embodiment of the invention, it is possible to use an average frequency of the detected frequencies over a predetermined period of time (for example, 1 second to 1 hour). In accordance with an embodiment of the invention, the rate of change of the frequency is preferably based on the change of the center frequency or the rate of change thereof. In accordance with such a preferred form, the crystallinity can be enhanced even more. Specifically, for example, the strain remaining in the crystal can be reduced to 5° or less, allowing the crystallinity to be enhanced even more. In accordance with such a preferred form, it is possible to further reduce the range of compositional error in the longitudinal direction of the crystal, enabling control within, for example, 1 atomic %, which is the general industrial standard.

High frequency (electromagnetic) waves are irradiated on the raw material workpiece under high frequency induction heating. The raw material workpiece is not limited in particular as long as it does not impede the objectives of the invention, and can include any of the raw material crystal (including the crystal rod) and molten materials, crucible, heat insulating material, stage, chamber, and surrounding parts of a high frequency induction heating coil, among others. According to an embodiment of the invention, it is possible to control the temperature, shape, electrical resistivity, dielectric constant, magnetic permeability, thermal conductivity, composition, and density, among others. In this embodiment, it is preferable that the raw material workpiece includes a crystal rod, since this can easily accommodate spike-like frequencies that may be generated by the crystal rod. In the embodiment of the invention, it is preferable to further include a continuous supply means for continuously supplying the raw material workpiece while controlling the raw material workpiece, since this allows for a higher degree of correlation between the rate of change of the frequency and the crystallinity. The continuous supply means is not limited in particular as long as it does not impede the objectives of the invention, and any known continuous supply means can be used. The raw material is not limited in particular in shape, among others, as long as it does not impede the objectives of the invention, and may be of any known material. The shape of the raw material may be, for example, droplets, powder, or granules, but the particle size is not limited in particular and can be set appropriately. The raw material is not limited in particular and can be of any known material for crystal growth. However, in this embodiment, it preferably includes a crystal rod for crystal growth, and more preferably is a droplet made of molten material of the crystal rod. The high-frequency induction heating is a heating method that uses high frequency waves to pass an electric current through an object based on the principle of electromagnetic induction, and can use a frequency of, for example, about 3 kHz to 300 MHz.

In accordance with embodiments of the invention, for example, the temperature of the raw material workpiece can be changed by heating the raw material (raw material workpiece) by induction heating, or by using an external heat source or a heating and cooling device to change the temperature of the components of the raw material workpiece, such as the molten material, crucible, insulation material, chamber, etc. The shape of the raw material workpiece can be changed by adding insulating material to the molten material, or by using Lorentz force or sound waves. The composition of the raw material workpiece can be changed by adding a raw material of different compositions to the molten material (raw material workpiece), or by volatilizing a part of the components constituting the raw material workpiece. The density of the raw material workpiece can be changed by forming bubbles in the molten material (raw material workpiece). The electrical resistivity, thermal conductivity, and emissivity can be changed by applying a substance to the surface of the raw material workpiece or by coloring it using an oxidation-reduction reaction. By using the method shown in the example above, the characteristics of the raw material workpiece can be changed to change the impedance of the entire equivalent oscillator circuit of the manufacturing apparatus including the raw material workpiece, thereby controlling the center frequency of the irradiated high frequency waves.

In this embodiment, it is preferable to further include a means for stopping the operation of the manufacturing apparatus in accordance with the rate of change of the center frequency during the frequency change, since this allows the crystal growth to be carried out more safely and efficiently. In this embodiment, it is preferable to have a cooling heat-treatment means for carrying out the growth by cooling heat-treatment, since this can further improve the crystal quality. The cooling heat-treatment means is not limited in particular, and may be any known cooling heat-treatment means (for example, gas introduction means).

In this embodiment, it is preferable to further include a means for driving the high frequency induction heating means, and it is more preferable that the high frequency induction heating means includes a heating coil, wherein the control is carried out by moving the position of the heating coil. According to such a preferable form, it is possible to more easily carry out the control without changing, for example, the condition of the raw material supply means.

In this embodiment, it is preferable to further include a means for driving the raw material workpiece, and it is more preferable to further include a supply amount adjustment means for adjusting the supply amount of the raw material workpiece, wherein the control is carried out by the supply amount adjustment means. Such a preferred form allows for more continuous supply and crystal growth.

In this embodiment, it is preferable that the manufacturing apparatus is a µ-PD device since it allows better control of various aspects such as composition control.

The alloy component according to an embodiment of the invention is an alloy component manufactured by the above-described crystal growth method.

The alloy component according to the embodiment of the invention contains a precious metal, has length of 30 meters or more, and has a composition error range of alloy elements in the longitudinal direction of 1 atomic % or less. The alloy component may be 35 meters or longer in length.

### Embodiment 1

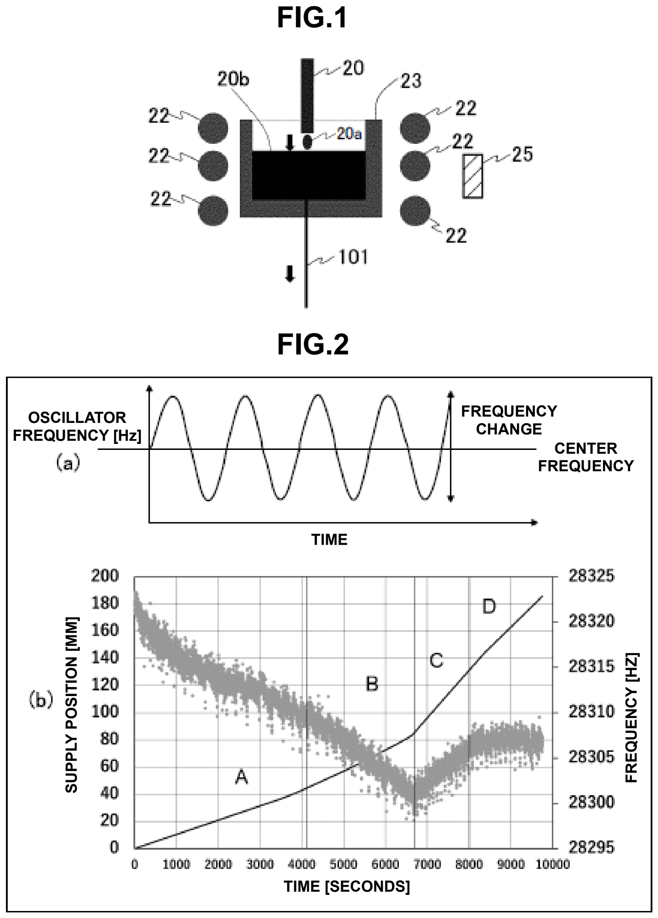

FIG. 1 schematically shows an example of a suitable form of the manufacturing apparatus according to an embodiment of the invention. FIG. 1 shows a crystal rod 20, molten material 20b, a high-frequency induction heating coil 22, a reaction vessel 23, and a wire 24. The manufacturing apparatus preferably grows a crystal by a micro pulling down method (µPD method). In this manufacturing apparatus, the supply rod is heated by using the high-frequency induction heating coil 22 which constitutes a high-frequency induction heating device, causing droplets 20a to fall from the crystal rod 20, allowing to grow a wire 24. As the growth proceeds, the amount of raw material (molten material 20b) decreases, and therefore the rate of change of the frequency is measured by a frequency measurement device 25. This is fed back to the supply speed of the supply rod under the control of a controller (not shown). This makes it possible to keep the change of the center frequency within a predetermined range, and to continuously supply the raw material by a continuous supply device (not shown). By adopting such a configuration, it is possible to easily produce a crystal with better crystallinity.

In FIG. 2, (a) schematically shows the relationship between the oscillator frequency and time when the center frequency is within a predetermined range during continuous supply of raw material during crystal growth; and
(b) shows the relationship between the oscillator frequency and supply position when the frequency changes and the center frequency changes during continuous supply of the raw material during crystal growth. In (b) in FIG. 2, the crystal growth progresses and the control is carried out as follows: For example, during range A (between the start and approximately 4100 seconds thereafter) when the rate of change of the frequency increases, the raw material workpiece or high-frequency induction heating coil can be adjusted by a known driving means (to control the growth condition for growing the crystal). For example, during range B (between approximately 4100 seconds and approximately 6700 seconds), the supply amount of raw material can be increased. For example, during range C (between approximately 6700 seconds and 8000 seconds), the center frequency is changed to a normal value. For example, during range D (from approximately 8000 seconds until the apparatus is stopped), the frequency remains within a predetermined range. It is possible to stop the apparatus if the center frequency does not change to the normal value in range C and the abnormality persists. By adopting such a configuration, a crystal having excellent crystallinity can be obtained more easily, and crystal growth can be carried out more safely.

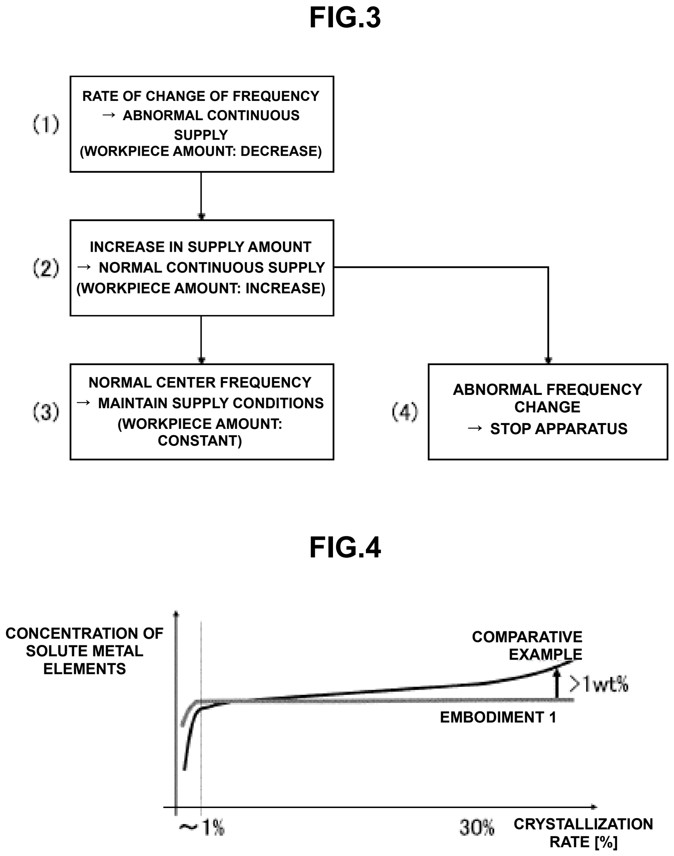

FIG. 3 schematically shows an example of a work amount flow adjusted according to the rate of change of the frequency in FIG. 2. (1) For example, if the rate of change of the frequency in range A increases, it is determined to be an abnormal continuous supply (decrease in work amount). (2) For example, during range B, the supply amount is increased to revert to normal continuous supply. (3) The center frequency is reverted to a normal state. If the supply amount is increased during range B, for example, but an abnormality in frequency change is still observed in range C, for example, (4) the apparatus is stopped.

### Embodiment 1 and Comparative Example: Production Evaluation Test

### 1. Alloy preparation

An alloy (crystal) was produced by continuously supplying a raw material by the micro-pulling-down method (µ-PD method) using a manufacturing apparatus according to an embodiment of the invention (Embodiment 1: the processing apparatus shown in FIG. 1). As a result, we were able to produce a product with excellent functionality and physical properties. As Comparative Example 1, a commercially available conventional manufacturing apparatus (without a frequency measurement device) was used. In Embodiment 1, the temperature of the raw material could be measured in real time, and therefore the supply rate was stable. Furthermore, since the raw material was continuously supplied, the crystal produced had good crystallinity. However, in Comparative Example where the frequency measurement device 25 was not used, the concentration of solute metal elements was not constant, and only a poor quality alloy (crystal) could be produced. In addition, the wire deteriorated quickly. As a result of comparing the product of Embodiment 1 with the product of Comparative Example, the concentration of solute metal elements varied in Comparative Example, but no variation was observed in Embodiment 1 as shown in FIG. 4. In FIG. 4, the crystallization rate (%) indicates the ratio of the crystal weight to the weight of the raw material.

### 2. Evaluation of the alloy component

The prepared Ru'_60_'Mo'_15_'W'_25_' alloy component had length of 34 meters as shown in FIG. 5. After annealing at 2000°C for 3 hours in an Ar atmosphere, the compositional error ranges of the alloy measured using a wavelength dispersive X-ray spectrometer apparatus were W: ±0.088 atomic % and Mo: ±0.036 atomic %, both of which were below the industrial standard of ±1 atomic %. The kernel average misorientation (KAM) value measured for the same sample by electron backscatter diffraction was 2° or less in 99% of the measurement range, revealing that the crystal had good quality with little distortion.

### Embodiment 2

An alloy component having length of 35 meters or more was produced in the same manner as in Embodiment 1. A good alloy component similar to that in Embodiment 1 was obtained.

### INDUSTRIAL APPLICABILITY

The manufacturing apparatus according to an embodiment of the invention is suitably used for manufacturing various crystal materials, for example.

### REFERENCE SYMBOLS LIST

20 : crystal rod, 20a: droplet, 20b: molten material, 22: coil, 23: reaction vessel, 24: wire,
25: frequency measurement device

## Claims

1. A manufacturing apparatus for growing a crystal through a thermal reaction of a raw material workpiece under high-frequency induction heating, wherein
the manufacturing apparatus comprises a frequency detection means for detecting a frequency associated with the high frequency induction heating; and
the raw material workpiece is controlled in accordance with a rate of change of the frequency detected by the frequency detection means.

2. The manufacturing apparatus according to claim 1, wherein
the raw material workpiece includes a crystal rod.

3. The manufacturing apparatus according to claim 1, further comprising a continuous supply means for continuously supplying the raw material workpiece while controlling the raw material workpiece.

4. The manufacturing apparatus according to claim 1, further comprising a means for stopping an operation of the manufacturing apparatus in accordance with a rate of change of a center frequency during a change of the frequency.

5. The manufacturing apparatus according to claim 1, further comprising a cooling heat-treatment means for carrying out the growth by cooling heat-treatment.

6. The manufacturing apparatus according to claim 1, further comprising a high-frequency induction heating means for carrying out the high-frequency induction heating.

7. The manufacturing apparatus according to claim 6, wherein
the high frequency induction heating means includes a heating coil; and the control is carried out by moving a position of the heating coil.

8. The manufacturing apparatus according to claim 1, further comprising a means for driving the raw material workpiece.

9. The manufacturing apparatus according to claim 8, further comprising a supply amount adjustment means for adjusting the supply amount of the raw material workpiece, wherein the control is carried out by the supply amount adjustment means.

10. The manufacturing apparatus according to claim 1, wherein
the manufacturing apparatus is a µ-PD device.

11. A crystal growth method for growing a crystal through a thermal reaction of a raw material workpiece under high-frequency induction heating, the method comprising:
a frequency detection step of detecting a frequency associated with the high frequency induction heating; and
a step of controlling the raw material workpiece in accordance with a rate of change of the frequency detected in the frequency detection step.

12. The crystal growth method according to claim 11, wherein
the raw material workpiece includes a crystal rod.

13. The crystal growth method according to claim 11, further comprising a step of continuously supplying the raw material workpiece while controlling the raw material workpiece.

14. The crystal growth method according to claim 11, wherein
an operation of the apparatus is stopped according to the rate of change of the center frequency in the frequency change.

15. The crystal growth method according to claim 11, wherein
the growth is carried out by a cooling heat-treatment.

16. The crystal growth method according to claim 11, wherein
the control is carried out by moving a high frequency induction heating portion of the high frequency induction heating.

17. The crystal growth method according to claim 11, wherein
the control is carried out by driving the raw material workpiece.

18. The crystal growth method according to claim 11, wherein
the control is carried out by adjusting the supply amount of the raw material workpiece.

19. The crystal growth method according to claim 11, wherein
the crystal is grown by a µ-PD method.

20. An alloy component manufactured according to the crystal growth method according to claim 11.

21. An alloy component containing a precious metal, wherein
length of the alloy component is 30 meters or more, and
a composition error range of alloy elements in the alloy component in a longitudinal direction of the alloy component is within 1 atomic %.

22. The alloy component according to claim 21, having length of 35 meters or more.
